# EUROPEAN PATENT APPLICATION

(11) **EP 2 362 230 A1**
(43) Date of publication of application: **31.08.2011**
(21) Application number: 10192132.8
(22) Date of filing: 22.11.2010
(51) Int. Cl.: G01P 1/00

(54) **MEMS sensor package**

(30) Priority: 18.02.2010 US 708074
(71) Applicant: Honeywell International Inc., Morristown, NJ 07962 (US)
(72) Inventor: Braman, Todd L., Morristown, NJ 07962-2245 (US); Karnick, Drew A., Morristown, NJ 07962-2245 (US); Glenn, Max C., Morristown, NJ 07962-2245 (US); Curtis, Harlan L., Morristown, NJ 07962-2245 (US)
(74) Representative: Buckley, Guy Julian

(57) **Abstract**

Methods and apparatus for a MEMS sensor package are provided. In one embodiment, a MEMS sensor package comprises a MEMS sensor; a sensor body permeable to gas leakage at a first leak rate; a backfill gas that pressurizes the sensor body to a backfill pressure; wherein the backfill pressure provides a dampening of the MEMS sensor; and wherein the backfill pressure is set such than any increase in pressure within the sensor body due to gas leakage will not cause a deviation in a Q value of the MEMS sensor beyond a predefined range for at least a specified design service life for the MEMS sensor package.

## Description

### CROSS-REFERENCE TO RELATED APPLICATIONS

This Application is a continuation-in-part of, and claims priority to, U.S. Application Serial Number 11/161,871 entitled "MEMS SENSOR PACKAGE" filed on August 19, 2005, which is herein incorporated by reference.

### BACKGROUND

The operational performance of micro electromechanical systems (MEMS) sensors, such as MEMS gyro sensors, is related to the quality (Q) value of the sensor. Having a sensor with a high Q value has both advantages and disadvantages. A high Q value means there is very little dampening in the system. Therefore it takes very little energy to excite the sensors and move the sensor components at their driving frequency. However, when a sensor having a high Q value is placed into an aircraft or other environment where vibration and shock are surrounding the sensor, noise at the driving frequency can cause loss of control of the MEMS sensor. Attenuation of this noise can be achieved through dampening of the sensor by backfilling the sensor chamber with a gas. That is, backfilling the sensor chamber with a gas will lower the Q value of the sensor so that vibration and shock noise will not generate an unstable sensor response. The resulting Q value is at least in part a function of the backfilled gas pressure. Thus, if the pressure within the sensor chamber changes over time the Q value for the sensor will also change over time. Thus, backfilled sensors to date have hermetically sealed sensor chambers (such as with a glass to metal bond, for example) so that the gas leak rate either into or out of the chamber is nearly zero. Such sealing processes are expensive and drive up the cost of producing MEMS sensors.

For the reasons stated above and for other reasons stated below which will become apparent to those skilled in the art upon reading and understanding the specification, there is a need in the art for improved systems and methods for MEMS sensor packages.

### SUMMARY

The Embodiments of the present invention provide methods and systems for improved systems and methods for MEMS sensor packages and will be understood by reading and studying the following specification.

Methods and apparatus for a MEMS sensor package are provided. In one embodiment, a MEMS sensor package comprises a MEMS sensor; a sensor body permeable to gas leakage at a first leak rate; a backfill gas that pressurizes the sensor body to a backfill pressure; wherein the backfill pressure provides a dampening of the MEMS sensor; and wherein the backfill pressure is set such than any increase in pressure within the sensor body due to gas leakage will not cause a deviation in a Q value of the MEMS sensor beyond a predefined range for at least a specified design service life for the MEMS sensor package.

### DRAWINGS

Embodiments of the present invention can be more easily understood and further advantages and uses thereof more readily apparent, when considered in view of the description of the preferred embodiments and the following figures in which:

Figure 1 is diagram of a MEMS sensor package of one embodiment of the present invention;

Figure 2 is a graph illustrating time versus leak rate for a sensor of one embodiment of the present invention;

Figure 3 is a graph illustrating the change in motor Q value for a sensor of one embodiment of the present invention as the pressure in the sensor's chamber changes;

Figure 4 is a graph illustrating the change in motor Q value for a sensor of one embodiment of the present invention over time;

Figure 5 is a flowchart illustrating a method of one embodiment of the present invention; and

Figure 6 is a graph illustrating a percent motor Q value change over time for a MEMS sensor package of one embodiment of the present invention.

In accordance with common practice, the various described features are not drawn to scale but are drawn to emphasize features relevant to the present invention. Reference characters denote like elements throughout figures and text.

### DETAILED DESCRIPTION

In the following detailed description, reference is made to the accompanying drawings that form a part hereof, and in which is shown by way of specific illustrative embodiments in which the invention may be practiced. These embodiments are described in sufficient detail to enable those skilled in the art to practice the invention, and it is to be understood that other embodiments may be utilized and that logical, mechanical and electrical changes may be made without departing from the scope of the present invention. The following detailed description is, therefore, not to be taken in a limiting sense.

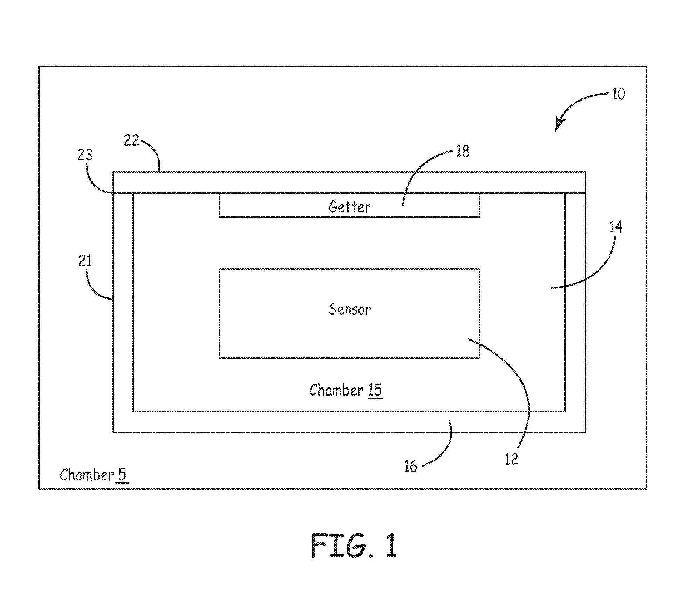

Figure 1 is a diagram illustrating a MEMS sensor package 10 of one body of the present invention. MEMS sensor package 10 comprises a sensor body 16 that defines a first chamber 15 which holds the MEMS sensor 12. The MEMS sensor 12 may be a MEMS Gyro sensor or any sensor with vibrating or moving parts that have performance characteristics based on a Q value. Typically, MEMS sensor package 10 would be housed within a second chamber 5. In one embodiment, the second chamber 5 would be backfilled to a pressure of one atmosphere with a gas such as air, for example. In one embodiment, the sensor body 16 is comprised of two or more component parts 21, 22 which when assembled, define the first chamber 15 within sensor body 16. The first chamber 15 is not hermetically sealed. That is, first chamber 15 is at least partially permeable to gasses through either of component parts 21, 22 or the seal 23 used to hold component parts 21, 22 together. For example in one embodiment component part 21 is affixed to part 22 using a solder seal. As such, first chamber 15 will possess a leak rate that is a function of the permeability of the seal 23 as well as parts 21, 22 themselves to gases within the first chamber 15 and second chamber 5.

With embodiments of the present invention, the first chamber 15 is backfilled with a gas 14 to a pressure that will maintain a Q value within specified design bounds for a certified life of the MEMS sensor package 10. Embodiments of the present invention are based on the principle that at higher backfilled pressures, pressure differentials over time due to gas entering or leaving chamber 15 have less of an effect on Q values than at relatively lower backfilled pressures. For example, if the pressure within the first chamber 15 is one micro-Torr and sufficient gas enters the first chamber to raise the pressure to 10 micro-Torr, the pressure and the chamber has risen tenfold. This will cause an appreciable change to the Q value of the sensor 10. If however, the pressure within the first chamber 15 is set to 44 mTorr and sufficient gas enters the chamber to raise the pressure by 10 micro-Torr, the effect on the Q value of sensor 10 will be negligible. This is because the percent pressure change would be less that 0.03%.

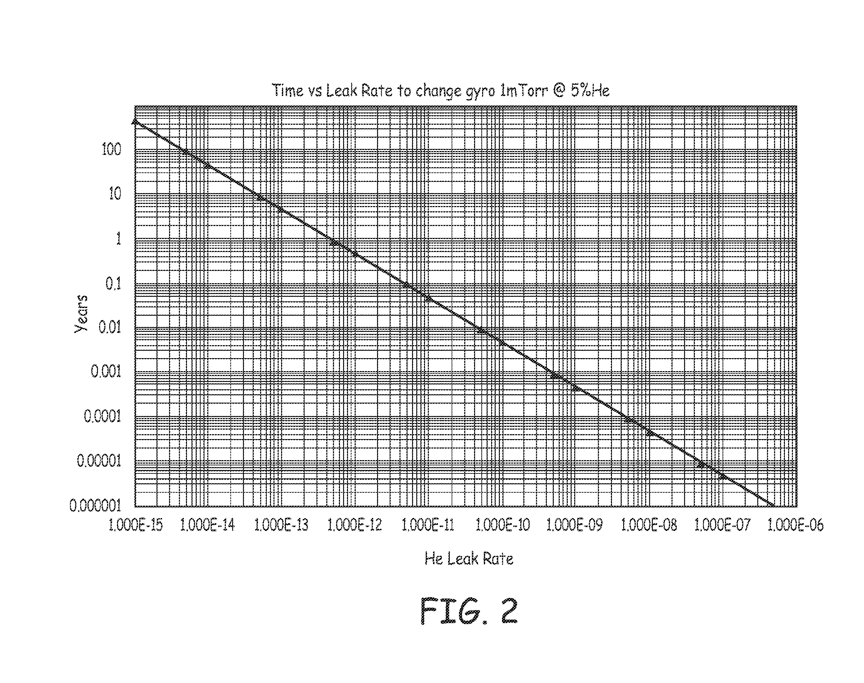

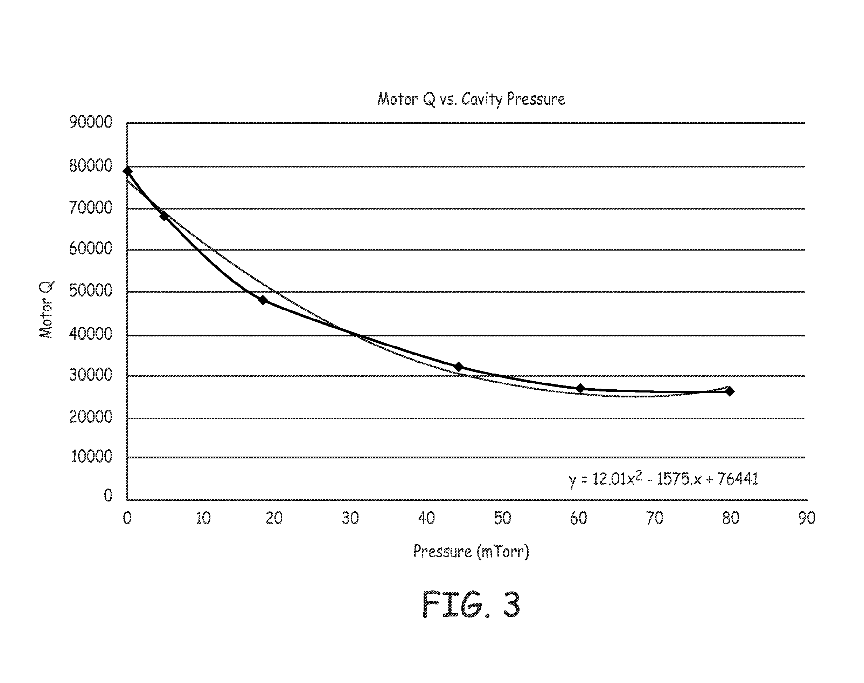

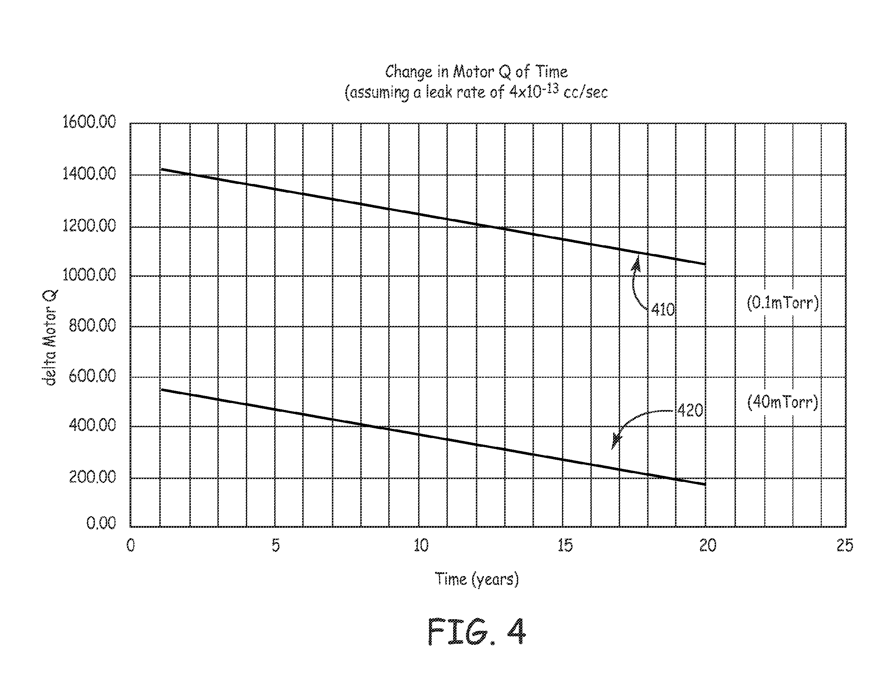

Figure 2 is a graph illustrating time versus leak rate for a sensor such as MEMS sensor package 10. As shown by the graph of figure 2, the greater the leak rate, the less time is necessary for the pressure within first chamber 15 to change by 1 mTorr. For example, a leak rate of 5x10⁻¹³ cm³ per second would result in a change in pressure within the first chamber 15 of one mTorr in slightly less than one year. Figure 3 is a graph illustrating the change in motor Q value for a sensor, such as MEMS sensor package 10, as the pressure in chamber 15 changes. For example, starting at a pressure of 5 mTorr, an increase in chamber pressure to approximately 12 mTorr will cause a resulting drop in Q value from 70,000 to 60,000. In contrast, starting at a pressure of 50 mTorr, a corresponding increase in chamber pressure to 57 mTorr would cause a resulting drop in Q value of less than 3000. Figure 4 is a graph illustrating the change in motor Q value for a sensor, such as MEMS sensor package 10, over time. Assuming a leak rate of 5x10⁻¹³ cm³ per second, the Q value of a sensor initially backfilled to only 100 micro-Torr (illustrated by the line shown generally at 410) would experience a change in Q value at a rate of approximately 1400 per year after one year. After 20 years, the rate of change for the sensors Q value would still be over 1000 per year. In contrast, the Q value of a sensor initially backfilled to 40 mTorr (illustrated by the line shown generally at 420) would experience a change in Q value at a rate of only approximately 550 per year after one year falling to under 200 per year after 20 years.

The choice of which gas to use to backfill chamber 15 can be readily determined by one of ordinary skill in the art upon reading the specification. The Q value provided by any particular gas would be a function of both backfill pressure and the size of the gas molecule. That is, backfilling chamber 15 to 40 mTorr with air would produce a different Q value than backfilling the chamber 15 to 40 mTorr with helium or argon. In addition, the leak rate of the sensor package would be calculated at least in part on the backfill gas selected. The backfill gas may be either an inert gas or a non-inert gas, or a mixture of inert and non-inert gases. Argon in particular has the advantage of being an inexpensive inert gas with a relatively large molecule size. However, embodiments of the present invention do not necessitate the use of argon as the backfill gas. For example, gases such as helium or oxygen may be used in alternate embodiments.

When the backfill chamber 15 includes an optional getter 18, an inert gas is preferred so that the getter 18 will not absorb the backfill gas so as to alter the Q value of the sensor. Getter 18 will otherwise function to absorb any non-inert gasses that enter chamber 15.

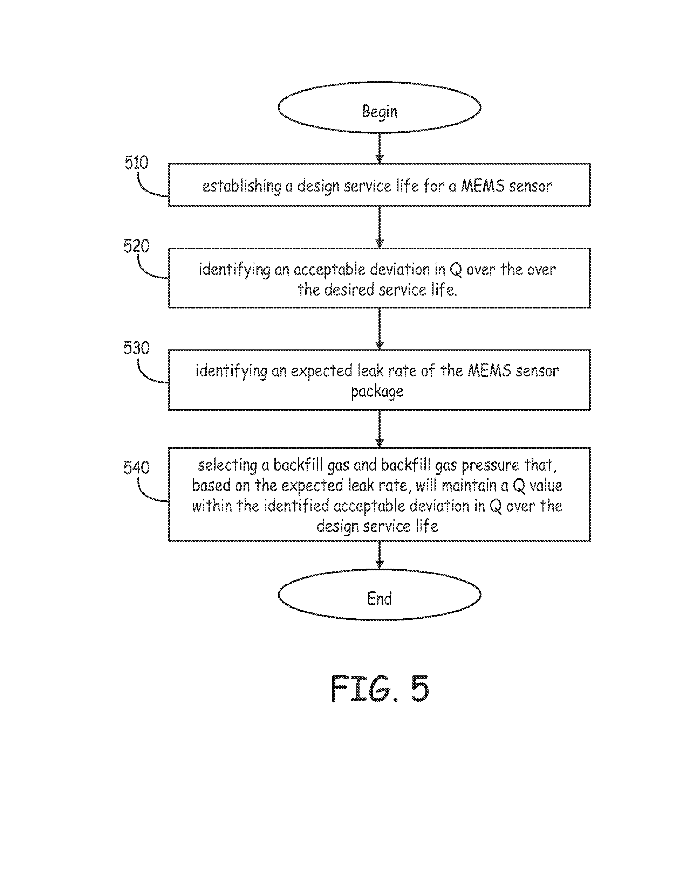

Figure 5 is a flowchart illustrating a method of one embodiment of the present invention for designing a MEMS sensor having a sufficiently stable Q value over a given design life. The method begins at 510 with establishing a design (i.e., a desired) service life of the MEMS sensor. The desired service life will be based on the particular mission in which a particular MEMS sensor will be employed, for example. The method proceeds to 520 with identifying what would be an acceptable deviation in Q over the over the desired service life. This may be at least partially based on the calibration tolerances, or the accuracy requirements of the system in which the MEMS sensor will be used. For example, if a device is calibrated to function assuming that the MEMS sensor will maintain a Q value of +/- 10% of its value at the time of calibration, then 10% deviation would be the maximum acceptable deviation in Q over the over the desired service life. The method proceeds to 530 with identifying an expected leak rate of the MEMS sensor package. They expected leak rate represents the permeability of the sensor package that will allow gases to enter or exit the sensor chamber. They expected leak rate would be based at least partially on the specific gas selected for backfilling the chamber. Identifying the expected leak rate may also be based on the composition and pressure of gases expected to surround the exterior of the MEMS sensor package. In one embodiment, identifying the expected leak rate may include incorporation of known sources of off-gassing within the sensor chamber due to materials used in construction of the MEMS sensor.

The method proceeds to 540 with selecting a backfill gas and backfill gas pressure that, based on the expected leak rate, will maintain a Q value within the identified acceptable deviation in Q over the design service life. Selection of the backfill gas may be based on factors such as economic considerations as well as the approximate desired range for the Q value of the sensor. For example, because different gases would produce different Q values over the same range of backfill pressures the selection of gas, in one embodiment, would be coordinated with an approximate desired Q value. For example an application such as an aircraft or a guided missile or projectile would benefit from the dampened response provided by a relatively lower Q value when compared to an application such as an orbiting platform because of the differences in expected vibrations and acoustic noises.

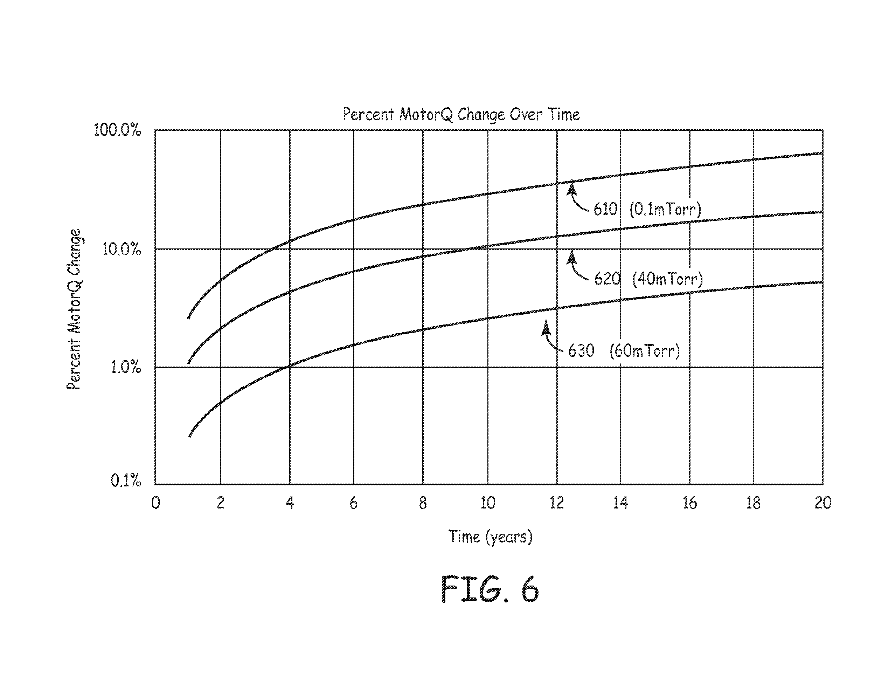

The selection of backfill gas pressure would then be based on maintaining the sensors Q value within the acceptable deviation range over the design life for the sensor. For example, Figure 6 is a graph illustrating a percent motor Q value change over time for a MEMS sensor package of one embodiment of the present invention. Figure 6 assumes a leak rate of 5x10⁻¹³ cubic centimeters per second for a MEMS sensor package having an internal open volume of 0.0075in³. The effects shown are proportional to the open volume of the package chamber holding the sensor, so if the volume of the sensor package is decreased by 50% the time to see a 20% change in Q (for example) would decrease by 50%. As shown in Figure 6, a sensor initially backfilled to only 100 micro-Torr (illustrated by the line shown generally at 610) would experience a change in Q value of more than 20% in less than 12 years. If a particular mission requires a MEMS sensor with a design service life of 20 years with an acceptable deviation in Q over the over the design service life not to exceed 20%, then the sensor represented by 610 would not be acceptable. A sensor initially backfilled to 40 mTorr (illustrated by the line shown generally at 620) would experience a change in Q value of slightly less than 20% over a 20 year lifespan. Therefore, selecting a backfill pressure of 40 mTorr would satisfy the acceptable deviation requirement over the design life of the sensor. If the acceptable deviation was 10% rather than 20%, then backfilling of the sensor to 60 mTorr would produce an acceptable sensor (as illustrated by the line shown generally at 630).

In practice, in one embodiment, the selected backfill gas is pumped into the chamber of the MEMS sensor package through an inlet in the package which is subsequently sealed after the desired backfill pressure is achieved. In one embodiment, the contents of the chamber are first evacuated prior to backfilling. In other embodiments, backfilling of the chamber forces any pre-existing gasses through an evacuation port in the package, which is also subsequently sealed.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the present invention. Therefore, it is manifestly intended that this invention be limited only by the claims and the equivalents thereof.

## Claims

1. A MEMS sensor package (10) comprising:
a MEMS sensor (12);
a sensor body (16) that defines a first chamber (15) housing the MEMS sensor (12),
wherein the sensor body (16) is permeable to gas leakage at a first leak rate, the first chamber (15) housing being non-hermetically sealed;
a backfill gas (14) that pressurizes the first chamber (15) to a backfill pressure that will cause the MEMS sensor (12) to maintain a Q value within a predefined deviation range for at least a specified design service life, given the first leak rate.

2. The MEMS sensor package (10) of claim 1, the sensor body (16) further comprising a plurality of component parts (21, 22) secured together by at least one seal (23).

3. The MEMS sensor package (10) of claim 2, wherein the at least one seal (23) is a solder seal.

4. The MEMS sensor package (10) of claim 1, further comprising a getter (18) within the first chamber (15), wherein the backfill gas is an inert gas.

5. The MEMS sensor package (10) of claim 1, wherein the first leak rate is at least 5x10⁻¹³ cubic-centimeters per second.

6. The MEMS sensor package (10) of claim 1, wherein the specified design service life of the MEMS sensor package (10) is at least 20 years.

7. The MEMS sensor package (10) of claim 1, wherein the backfill gas (14) includes at least one of Argon, Oxygen, Helium or Air.

8. The MEMS sensor package (10) of claim 1, wherein the backfill gas (14) maintains a sufficient backfill pressure, based on the volume of the chamber (15) and first leak rate, to maintain the Q value within the predefined deviation range for at least the specified design service life.

9. A method for providing a MEMS sensor package having a stable Q value over a design service life, the method comprising:
establishing a design service life for a MEMS sensor (510);
identifying an acceptable deviation in Q over the over the design service life (520);
identifying an expected leak rate of the MEMS sensor package (530); and
selecting a backfill gas (14) and backfill gas pressure that, based on the expected leak rate, will maintain a Q value within the identified acceptable deviation in Q over the design service life (540).

10. The method of claim 9, wherein the MEMS sensor package comprises a sensor body having a plurality of component parts secured together by at least one seal, the at least one seal and sensor body forming a non-hermetically sealed chamber holding the MEMS sensor;
wherein one or both of the backfill gas (14) and backfill gas pressure are selected based on a volume of a chamber (15) of the MEMS sensor package housing the MEMS sensor (12); and
wherein identifying an expected leak rate is based at least in part on molecular characteristics of the backfill gas.
